# FASCICULE DE BREVET EUROPEEN

(11) **EP 2 354 832 B1**
(45) Date de publication et mention de la délivrance du brevet: **25.12.2013**
(21) Numéro de dépôt: 11290073.3
(22) Date de dépôt: 02.02.2011
(51) Int. Cl.: G02B 26/08

(54) **Elément optique bimorphe**
Bimorphes optisches Element
Bimorph optical element

(30) Priorité: 05.02.2010 FR 1000471
(43) Date de publication de la demande: 10.08.2011
(73) Titulaire: Thales SESO, 13090 Aix en Provence (FR)
(72) Inventeur: Carré, Jean-Francois, 84120 Pertuis (FR)
(74) Mandataire: Reboussin, Yohann Mickaël Noël

(56) Documents cités:
- EP-A2- 1 835 302
- FR-A1- 2 866 122

## Description

La présente invention a pour objet un élément optique bimorphe commandé par des éléments actifs en céramique piezo-électriques actionnés en opposition.

La Demande de Brevet Européen EP 1 723 461 concerne un miroir bimorphe présentant deux couches céramiques pourvues d'électrodes et séparées par une âme centrale.

Un tel miroir est assemblé sous forme de structure feuilletée comportant deux couches dites de peau dont une au moins est utilisée comme miroir, les deux couches céramiques et l'âme centrale étant prises en sandwich entre deux couches de peau.

La mise en oeuvre d'une structure feuilletée est relativement compliquée et délicate.

Le concept de structure feuilletée qui prévaut pour les miroirs bimorphes limite également la dimension des miroirs aux dimensions des éléments de céramique et à leurs multiples, et la qualité du polissage du miroir est limitée par la présence de la structure feuilletée.

En effet, les solutions connues sont toujours basées sur l'assemblage d'éléments de céramiques sur une face parallèle à la face optique utile.

Dans tous les cas, les céramiques sont en effet collées sur une face parallèle à la face optique, ce qui conduit à une structure feuilletée dans la direction perpendiculaire à la face optique.

C'est également le cas du document EP 1 835 302 pour lequel les céramiques sont collées sur la face opposée à la face optique.

Dans le cas où les barreaux de céramique sont bimorphes, c'est-à-dire que les barreaux comportent deux céramiques contre-collées, la stabilité est limitée par l'effet bilame lorsque la température de l'ensemble change.

De plus, si le miroir déformable est de plus grandes dimensions que les éléments de céramiques (ce qui est très souvent le cas en raison des dimensions limitées des céramiques disponibles dans le commerce), le constructeur doit abouter plusieurs morceaux de céramique pour obtenir les dimensions nécessaires, et dans le cas du document EP 1 835 302, ces jonctions entre morceaux de céramique se situent sur la face arrière non optique de miroir et cette discontinuité apparaît lorsqu'on met en contrainte des céramiques pour obtenir le changement de courbure du miroir.

La présente invention vise à éviter au moins en partie au moins un des inconvénients précités en adoptant une structure dans laquelle les éléments piezo-électriques sont disposés latéralement par rapport à un élément optique qui ne présente plus une telle structure feuilletée, laquelle intégrerait les éléments piezo-électriques.

L'invention concerne ainsi un dispositif optique bimorphe comportant un élément optique déformable et des éléments actifs en céramique piezo-électriques pourvus d'électrodes, ces éléments étant commandés par paires en opposition pour produire un déplacement en compression pour un premier élément d'une paire et un déplacement en extension pour le deuxième élément d'une paire, caractérisé en ce que l'élément optique présente une première surface principale optiquement active et une deuxième surface principale opposée à la première surface principale et ainsi qu'au moins une première et une deuxième faces latérales opposées, et en ce que les éléments actifs en céramique comportent au moins deux paires de barreaux de céramique piezo-électriques disposés en vis-à-vis sur lesdites première et deuxième faces latérales, chaque paire comportant deux barreaux disposés sur une des première et deuxième faces latérales de part et d'autre d'une surface médiane de l'élément optique qui en constitue la fibre neutre.

Dans le cas du dispositif selon l'invention, le principe exposé est d'office bimorphe, car il est constitué de paires de céramiques opposées disposées de part et d'autre de la fibre neutre de l'élément optique déformable, ce qui fait qu'ils fonctionnent en opposition, l'un étant en compression et l'autre en extension et vice versa.

De plus, les céramiques ne sont pas collées sur une face parallèle à la face optique ou entre des faces parallèles à la face optique, mais latéralement sur les côtés. La structure n'est donc plus feuilletée.

Contrairement aux dispositifs connus, dont celui qui est décrit dans le document EP 1 835 302, ce n'est pas directement la courbure des céramiques qui est utilisée pour courber le miroir.

Les barreaux de céramique sont collés sur les faces latérales de l'élément optique par leur face latérale. Dans l'art antérieur, la face en appui ne reste pas plane, mais épouse au contraire une courbure qui produit à son tour la courbure du miroir.

Selon l'invention la face latérale des barreaux reste plane, et l'action sur les barreaux de céramiques entraîne leur variation de longueur. C'est la réaction du barreau à cette variation de longueur qui crée la courbure. La courbure générée par l'action des barreaux sur les faces latérales du miroir se répartit de manière homogène au centre du miroir, contrairement à ce qu'on pouvait attendre.

C'est donc à la suite d'une analyse fonctionnelle originale que la présente invention a pu être réalisée.

Cette disposition présente en outre plusieurs avantages.

Le plus important est que les éléments céramiques sont placées au niveau des faces externes, donc de part et d'autre et au plus loin de la fibre neutre par rapport à la structure feuilletée décrite dans la Demande EP 1 723 461, permettant ainsi une action maximale sur le miroir.

Cette action, de par le meilleur couplage céramique-miroir permet une meilleure précision et une meilleure stabilité du miroir lorsqu"il est courbé.

Les céramiques n'étant plus directement sous ou sur la surface optique, les jonctions entre les éléments céramiques sont moins visibles et leur effet est lissé dans la largeur du miroir.

La structure réalisée est, contrairement au cas de la Demande EP 1 835 302, symétrique par rapport à la fibre neutre de l'élément optique, évitant tout effet thermique bilame (même si les barreaux industriels peuvent être formés de plusieurs éléments céramiques contre-collés) d'où une très bonne stabilité thermique.

Ces avantages sont particulièrement intéressants dans le cas où l'on transforme un miroir traditionnel en miroir bimorphe, car la solution d'ajouter en face arrière des céramiques (monomorphe ou bimorphe) n'est qu'une adaptation a minima ne donnant qu'une plus faible dynamique et occasionnant un effet thermique bilame.

Au moins un barreau de céramique peut avoir une face coplanaire avec une dite surface principale.

Le dispositif peut être caractérisé en ce qu'au moins une des surfaces principales intersecte la première et la deuxième faces latérales selon un segment de droite et en ce qu'au moins certains desdits barreaux de céramique sont droits et sont disposés parallèlement audit segment de droite.

Le dispositif peut être caractérisé en ce qu'au moins une des surfaces principales intersecte la première et la deuxième faces latérales selon un segment de courbe concave ou convexe et en ce qu'au moins certains desdits barreaux de céramique sont droits et sont disposés parallèlement à la direction moyenne dudit segment de courbe.

Le dispositif peut être caractérisé en ce qu'au moins une des surfaces principales intersecte la première et la deuxième faces latérales selon un segment de courbe concave ou convexe et en ce qu'au moins certains desdits barreaux de céramique sont courbes et sont disposés de manière à suivre ledit segment de courbe.

Au moins un barreau de céramique peut comporter au moins deux éléments en céramique piezo-électriques mis bout à bout et/ou superposés.

L'élément optique est avantageusement parallélépipédique de préférence carré ou rectangulaire et les première et deuxième faces latérales sont disposées selon le plus grand côté dans le cas d'un rectangle.

Le rapport entre la longueur L et la largeur 1 du parallélépipède est avantageusement compris entre 1 et 100, plus particulièrement entre 3 et 50 et de préférence entre 3 et 25.

La largeur 1 peut être par exemple comprise entre 10 mm et 80 mm.

La longueur L peut être par exemple comprise entre 40 mm et 1500 mm.

L'épaisseur e de l'élément optique peut être par exemple comprise entre 5 mm et 100 mm.

Le dispositif optique peut également comporter au moins deux dites paires de barreaux de céramique piézo-électriques disposés de la même façon sur une troisième et une quatrième faces latérales opposées.

Du fait que le dispositif selon l'invention met en oeuvre des actionneurs piézo-électriques en opposition qui sont simplement solidarisés à deux ou quatre faces latérales, il peut être mis en oeuvre pour tout dispositif optique déformable.

L'élément optique est par exemple un corps de miroir et au moins la première surface principale est polie.

L'élément optique est par exemple un réseau et au moins la première surface principale présente au moins un motif de réseau.

D'autres caractéristiques et avantages de l'invention apparaîtront mieux à la lecture de la description qui va suivre, en liaison avec les dessins dans lesquels :
- la figure 1 est une vue en perspective d'un dispositif selon l'invention, par exemple un miroir,
- la figure 2 est une vue latérale de la figure 1,
- la figure 3 est une variante selon laquelle les barreaux sont écartés de la surface de l'élément optique,
- les figures 4a et 4b sont deux variantes de mise en oeuvre des paires d'électrodes,
- la figure 5 illustre la mise en oeuvre de paires d'électrodes sur quatre faces latérales,
- et les figures 6a à 6c représentent des variantes de mise en oeuvre avec au moins une face principale courbe.

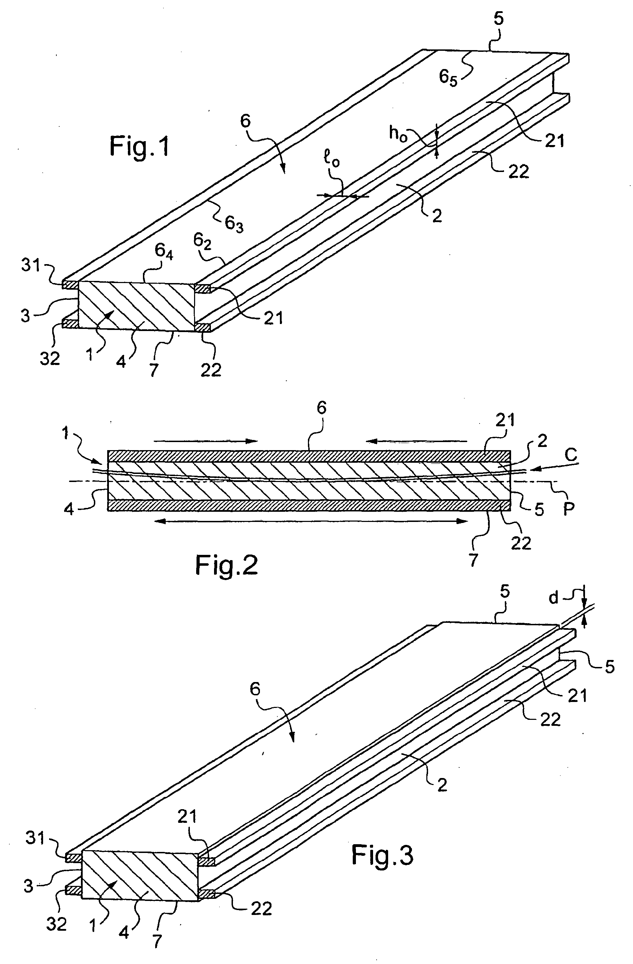

La figure 1 montre un élément optique déformable 1 de forme rectangulaire qui présente deux faces latérales principales 2 et 3 selon le grand côté du rectangle et deux faces latérales d'extrémité 4 et 5. La face supérieure 6 présente une fonction optique, par exemple elle est polie pour former un miroir plan ou incurvé (concave ou convexe) dans la direction longitudinale et/ou dans la direction transversale, ou bien elle porte un ou plusieurs motifs de réseau dont les traits sont par exemple perpendiculaires au grands côtés du rectangle ou bien parallèles à ceux-ci, pour former un réseau plan ou incurvé (concave ou convexe) dans la direction longitudinale et/ou dans la direction transversale, qui fonctionne en réflexion ou en diffraction.

La face latérale 2 porte une première paire de barreaux piézo-électriques 21, 22 qui sont sensiblement parallèles au plan médian P (en traits mixtes à la figure 2) de l'élément optique 1 qui en définit la fibre neutre (lorsque les plans 6 et 7 sont plans ou faiblement courbés) et qui en sont espacés de préférence symétriquement. Il en va de même pour les barreaux 31 et 32 solidaires de la face latérale 3. Lorsqu'au moins une face est incurvée, la fibre neutre est une surface médiane non plane.

La surface 6 peut être plane, cylindrique, torique, sphérique ou asphérique (par exemple elliptique, parabolique ou hyperbolique), donc avec des rayons de courbure qui sont ou non constants. Dans l'exemple représenté, la face 6 est plane et est délimitée par les segments de droite 6₂, 6₃, 6₄ et 6₅.

La face inférieure 7 peut présenter ou non des fonctions optiques, et comme la face supérieure 6, elle peut être plane ou bien être incurvée (concave ou convexe).

La gamme des rayons de courbure de la face 6 (et/ou 7) est par exemple compris entre 10 mm et ∞ (surface plane) dans une direction ne portant pas de barreaux piézo-électriques (ici faces transversales 4 et 5) et entre 100 mm et ∞ dans la direction (ici faces longitudinales 2 et 3) portant des barreaux piézo-électriques.

Ce ou ces courbures peuvent également être mises en oeuvre dans le cas d'un élément optique 1 de forme carrée.

Cette courbure est orientée dans la même direction que la courbure produite par des paires d'éléments piézo-électriques 21, 22, 31, 32, ou perpendiculairement.

Chaque barreau 21, 22, 31, 32 est constitué d'un morceau ou de plusieurs morceaux raboutés en céramique piézo-électrique.

Ces barreaux piézo-électriques 21, 22, 31, 32 viennent de préférence à l'aplomb des faces 6 et 7, ce qui permet de les écarter au maximum de la fibre neutre et donc d'obtenir la courbure maximale de l'élément optique 1 pour une commande donnée des barreaux, tout en minimisant la contrainte dans le collage des barreaux.

Les barreaux 21 et 22 sont en opposition, et par exemple une même commande appliquée à leurs électrodes (non représentées) permet de commander le barreau 21 en compression et le barreau 22 en extension, comme représenté à la figure 2 ou inversement. A la figure 2, on a représenté schématiquement (en l'exagérant) la courbure de l'élément optique 1, pour modifier la courbure de sa face optiquement active 6 pour lui conférer un profil concave C à partir d'une face plane.

Le fait de partir d'une face 6 concave ou convexe permet de déplacer la plage de variation des courbures sans modifier l'amplitude du déplacement.

Les barreaux 21, 22, 31, 32 sont collés sur les faces latérales 2 et 3. Ils s'étendent de préférence sur toute la longueur de ces faces. Dans le cas d'un miroir, le collage peut être réalisé après le polissage de la face 6, ce qui facilite la fabrication, d'autant que la pièce 1 est monolithique.

Cette particularité permet de transformer un miroir passif préexistant en miroir actif, ce que ne permettraient pas les structures feuilletées.

Dans le cas d'autres éléments optiques, en particulier les réseaux, le collage des barreaux piézo-électriques 21 22, 31, 32 peut être effectué après la finition de la face 6, c'est-à-dire après que des caractéristiques optiques lui aient été conférées.

Par rapport aux miroirs à structure feuilletée, les morceaux de céramiques utilisés sont plus petits, car ils ne recouvrent pas la surface du miroir, ce qui diminue les coûts. Leur dimension peut donc être adaptée à la valeur de la courbure qui est souhaitée. Par exemple, un barreau peut voir une largeur l₀ comprise entre 2 mm et 30 mm et une hauteur h₀ comprise entre 2 mm et 30 mm. De plus, comme il n'y a pas d'électrode sous une couche de peau constituant le miroir, il n'y a plus localement de déformation due aux jonctions entre les électrodes.

L'élément optique 1 peut être en tout matériau utilisable en optique : par exemple verre, silice, silicium, carbure de silicium, germanium, verre pour laser, ZnS et ZnSe, métaux.

La figure 3 montre une variante dans laquelle les barreaux de céramique 21, 22,31, 32 sont espacés des surfaces 6 et 7, par exemple d'une distance d inférieure à 10 mm et par exemple comprise entre 0,1 mm et 4 mm. Ceci convient notamment au cas des surfaces 6 concaves ou convexes.

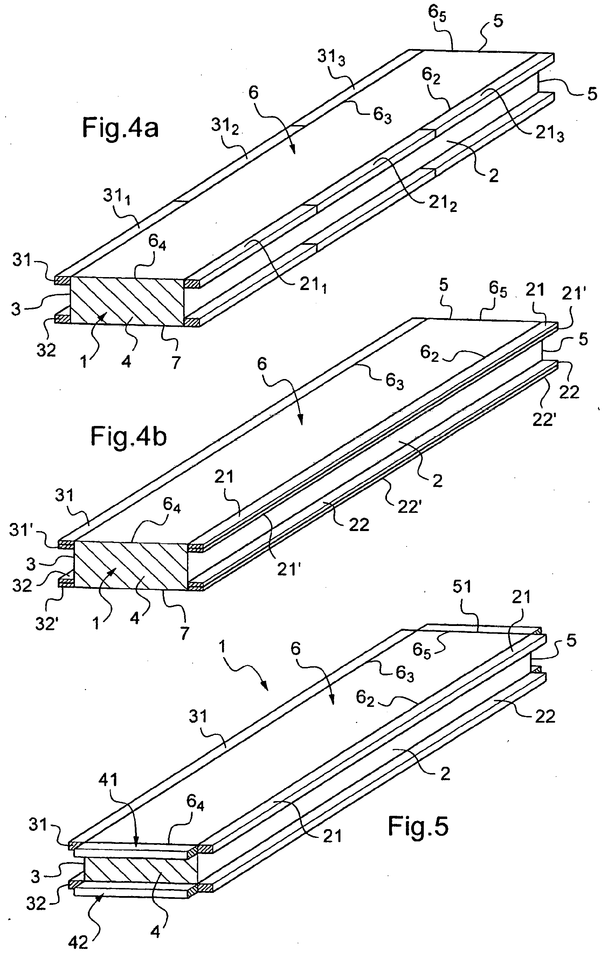

Les figures 4a et 4b illustrent des variantes de réalisation de l'invention, avec des barreaux élémentaires 21₁, 21₂, 21₃, 22₁, 22₂, 22₃, 31₁, 31₂, 31₃, etc... mis bout à bout (figure 4a) et/ou superposés figure 4b (réf. 21, 21', 22, 22').

Dans le cas où plusieurs barreaux de céramique piézo-électriques sont collés bout à bout (cas de miroirs de grandes longueurs), les jonctions qui sont reportées sur les faces latérales 2 et 3 de l'élément optique 1 ne créent plus de défauts de planéité sur la surface optiquement active 6. De tels défauts ne peuvent pas non plus apparaître au cours du temps (figure 4a).

Un barreau 21, 22, 31, 32 peut être formé de la superposition de deux barreaux élémentaires collés entre eux (figure 4b).

La figure 5 montre un miroir bimorphe qui peut être courbé selon deux axes perpendiculaires, grâce à des barreaux piézo-électriques supplémentaires 41, 42, 51, 52 collés sur les faces 4 et 5 d'un élément optique 1 carré ou rectangulaire, et espacés de préférence symétriquement du plan médian P qui en constitue la fibre neutre quand les surfaces 6 et 7 sont planes ou faiblement courbes. Ces barreaux 41, 42, 51, 52 ont une face qui vient de préférence à l'aplomb des faces 6 et 7 ou bien qui en sont espacés comme dans le cas de la figure 3. La surface 6 et/ 7 peut être plane ou incurvée selon une ou deux des directions de courbure produite par les paires d'éléments piezo-électriques, ou perpendiculairement à une telle direction. La gamme des rayons de courbure peut être comprise entre 100 mm et ∞.

Ce double actionnement par deux paires d'actionneurs piézo-électriques latéraux est utilisable notamment pour des pièces optiques de forme carrée ou rectangulaire. Le rapport L/1 peut être compris entre 1 (carré) et 5.

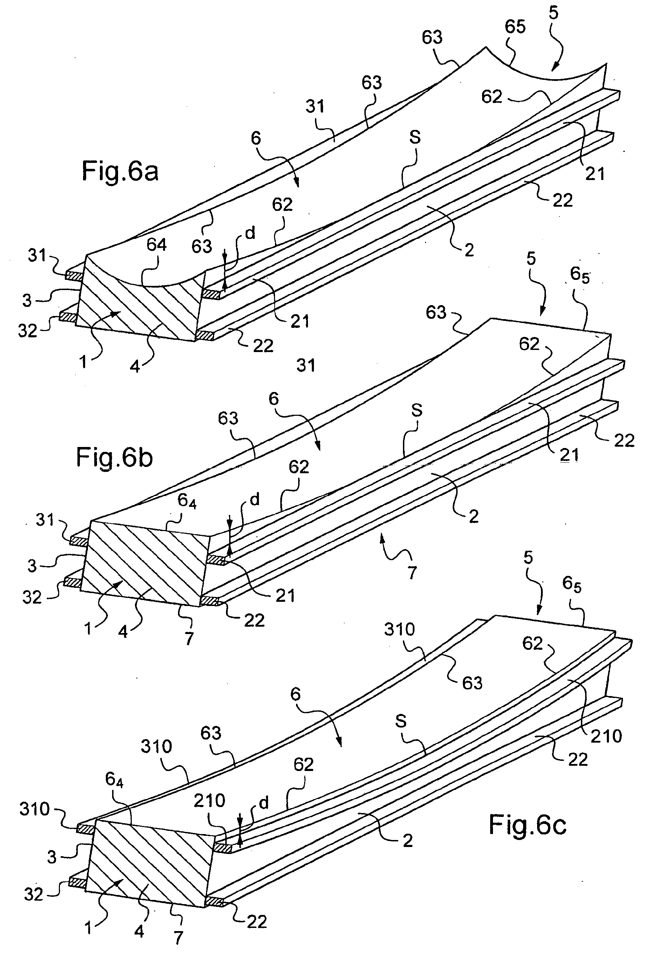

La figure 6a illustre le cas d'un miroir dont la surface principale supérieure 6 polie est concave aussi bien dans la direction longitudinale que dans la direction transversale. Les barreaux 21, 22, 31, 32 sont droits et disposés longitudinalement.

Ils sont parallèles l'un à l'autre et dirigés dans la direction moyenne du segment de courbe 62 ou 63 qui représente l'intersection entre la surface supérieure 6 et la face latérale 2 ou 3. Les segments de courbe 64 et 65 correspondent à l'intersection de la face supérieure 6 aux faces latérales respectivement 4 et 5. Dans l'exemple représenté, cette direction est parallèle à la face inférieure 7 qui est plane, mais cette face pourrait être convexe ou concave dans la direction longitudinale et/ou transversale. Cette direction est en général parallèle à la tangente au sommet S, notamment pour des segments de courbe en forme de parabole ou d'hyperbole. Cette disposition peut être mise en oeuvre également dans le cas où la face supérieure 6 n'est courbe que dans le sens longitudinal (figure 6b). L'intersection entre la face supérieure 6 et les faces latérales 4 et 5 se fait alors selon les segments de droite 6₄ et 6₅.

La figure 6c illustre le cas d'un miroir dont la surface supérieure 6 polie est concave dans la direction longitudinale. Les barreaux 210 et 310 qui jouxtent cette surface 6 suivent le segment de courbe 62 ou 63 qui représente l'intersection entre la surface supérieure 6 et la face latérale 2 ou 3. Les barreaux 22 et 32 sont droits et sont dirigés dans la direction longitudinale parallèlement à la face inférieure 7. Dans l'exemple représenté, les barreaux 21 et 31 sont espacés de ladite distance d de la surface supérieure 6. Ils pourraient également venir à l'aplomb du segment de courbe.

Les barreaux droits ou courbes sont ainsi disposés de manière à suivre au plus près les segments de droite (6₂, 6₃, 6₄, 6₅) ou les segments de courbe (62, 63, 64, 65), à une distance d qui est constante ou non, mais qui est inférieure ou égale à 10 mm, et notamment à 4 mm.

## Revendications

1. Dispositif optique bimorphe comportant un élément optique déformable et des éléments actifs en céramique piezo-électriques pourvus d'électrodes, ces éléments étant commandés par paires en opposition pour produire un déplacement en compression pour un premier élément d'une paire et un déplacement en extension pour le deuxième élément d'une paire, l'élément optique (1) présentant une première surface principale (6) optiquement active et une deuxième surface principale (7) opposée à la première surface principale, ainsi qu'au moins une première (2) et une deuxième (3) faces latérales opposées, les éléments actifs en céramique comportant au moins deux paires de barreaux de céramique piezo-électriques (21, 22 ; 31, 32), **caractérisé en ce que**
les au moins deux paires de barreaux de céramique piezo-électrique sont disposés en vis-à-vis sur lesdites première (2) et deuxième (3) faces latérales, chaque paire (21, 22 ; 31, 32) comportant deux barreaux disposés sur une des première (2) et deuxième (3) faces latérales de part et d'autre d'une surface médiane de l'élément optique (1) qui en constitue la fibre neutre.

2. Dispositif optique bimorphe selon la revendication 1, **caractérisé en ce qu'**au moins une des surfaces principales (6, 7) intersecte la première (2) et la deuxième (3) faces latérales selon un segment de droite (6₂, 6₃, 6₄, 6₅) et **en ce qu'**au moins certains desdits barreaux de céramique (21, 31) sont droits et sont disposés parallèlement audit segment de droite.

3. Dispositif optique bimorphe selon la revendication 1, **caractérisé en ce qu'**au moins une des surfaces principales (6, 7) intersecte la première (2) et la deuxième (3) faces latérales selon un segment de courbe (62, 63, 64, 65) concave ou convexe et **en ce qu'**au moins certains desdits barreaux de céramique (21, 31) sont droits et sont disposés parallèlement à la direction moyenne dudit segment de courbe.

4. Dispositif optique bimorphe selon la revendication 1, **caractérisé en ce qu'**au moins une des surfaces principales (6, 7) intersecte la première (2) et la deuxième (3) faces latérales selon un segment de courbe (62, 63, 64, 65) concave ou convexe et **en ce qu'**au moins certains desdits barreaux de céramique (210, 310) sont courbes et sont disposés de manière à suivre ledit segment de courbe.

5. Dispositif optique bimorphe selon la revendication 1, **caractérisé en ce qu'**au moins un barreau de céramique comporte au moins deux éléments en céramique piezo-électrique mis bout à bout (21₁, 21₂, 21₃, 22₁, 22₂, 22₃, 31₁, 31₂, 31₃) et/ou superposés (21, 21', 22, 22', 31, 31', 32, 32').

6. Dispositif optique bimorphe selon une des revendications précédentes, **caractérisé en ce que** l'élément optique (1) est parallélépipédique et **en ce que** lesdites première (2) et deuxième (3) faces latérales sont disposées selon le plus grand côté du rectangle.

7. Dispositif optique bimorphe selon la revendication 6, **caractérisé en ce que** le rapport entre la longueur L et la largeur 1 dudit parallélépipède est compris entre 1 et 100.

8. Dispositif optique bimorphe selon la revendication 7, **caractérisé en ce que** la largeur 1 est comprise entre 10 mm et 80 mm.

9. Dispositif optique bimorphe selon une des revendications 7 ou 8, **caractérisé en ce que** la longueur L est comprise entre 40 mm et 1500 mm.

10. Dispositif optique bimorphe selon une des revendications précédentes, **caractérisé en ce que** la largeur l₀ d'un barreau (21, 22, 31, 32, 41, 42, 51, 52) est comprise entre 2 mm et 30 mm et **en ce que** sa hauteur h₀ est comprise entre 2 mm et 30 mm.

11. Dispositif optique bimorphe selon une des revendications 6 à 10, **caractérisé en ce qu'**il comporte également une troisième (4) et une quatrième (5) faces latérales opposées comportant au moins deux dites paires de barreaux de céramique piézo-électriques (41, 42, 51, 52).

12. Dispositif optique bimorphe selon une des revendications précédentes, **caractérisé en ce que** l'épaisseur e de l'élément optique (1) est comprise entre 5 mm et 100 mm.

13. Dispositif optique bimorphe selon une des revendications précédentes, **caractérisé en ce que** l'élément optique est un corps de miroir et **en ce qu'**au moins la première surface principale (6) est polie.

14. Dispositif optique bimorphe selon une des revendications 1 à 12, **caractérisé en ce que** l'élément optique est un réseau et **en ce qu'**au moins la première surface principale (6) porte au moins un motif de réseau.

## Patentansprüche

1. Bimorphe optische Vorrichtung, umfassend ein verformbares optisches Element und mit Elektroden versehene aktive keramische piezo-elektrische Elemente, wobei diese Elemente gesteuert werden durch gegenüberliegende Paare, zur Erzeugung einer Kompressionsbewegung für ein erstes Element eines Paares und einer Dehnbewegung für das zweite Element eines Paares, wobei das optische Element (1) eine erste optisch aktive Hauptfläche (6) und eine zweite Hauptfläche (7) gegenüber der ersten Hauptfläche, sowie wenigstens eine erste (2) und eine zweite (3) gegenüberliegende laterale Fläche aufweist, wobei die aktiven keramischen Elemente wenigstens zwei Paare von piezo-elektrischen Keramikstäben (21, 22; 31, 32) aufweisen, **dadurch gekennzeichnet, dass**
die wenigstens zwei Paare von piezo-elektrischen Keramikstäben einander gegenüber auf den ersten (2) und zweiten (3) lateralen Seiten angeordnet sind, wobei jedes Paar (21, 22; 31, 32) zwei Stäbe umfasst, welche auf einer der ersten (2) und zweiten (3) lateralen Fläche auf beiden Seiten einer Mittelfläche des optischen Elements (1) angeordnet ist, welche die neutrale Faser bildet.

2. Bimorphe optische Vorrichtung nach Anspruch 1, **dadurch gekennzeichnet, dass** wenigstens eine der Hauptflächen (6, 7) die erste (2) und zweite (3) laterale Fläche entlang einem Geradenabschnitt (6₂, 6₃, 6₄, 6₅) schneidet, und dass wenigstens bestimmte der Keramikstäbe (21, 31) gerade sind und parallel zu dem Geradensegment angeordnet sind.

3. Bimorphe optische Vorrichtung nach Anspruch 1, **dadurch gekennzeichnet, dass** wenigstens eine der Hauptflächen (6, 7) die erste (2) und die zweite (3) laterale Fläche entlang einem konkaven oder konvexen Kurvensegment (6₂, 6₃, 6₄, 6₅) schneidet, und dass wenigstens bestimmte der Keramikstäbe (21, 31) gerade sind und parallel zu der Durchschnittsrichtung des Kurvensegments angeordnet sind.

4. Bimorphe optische Vorrichtung nach Anspruch 1, **dadurch gekennzeichnet, dass** wenigstens eine der Hauptflächen (6, 7) die erste (2) und die zweite (3) laterale Fläche entlang eines konkaven oder konvexen Kurvensegments (62, 63, 64, 65) schneidet, und dass wenigstens bestimmte der Keramikstäbe (210, 310) gekrümmt sind und auf dem Kurvensegment folgende Weise angeordnet sind.

5. Bimorphe optische Vorrichtung nach Anspruch 1, **dadurch gekennzeichnet, dass** wenigstens ein Keramikstab wenigstens zwei piezo-elektrische keramische Elemente umfasst, welche Ende an Ende (21₁, 21₂, 21₃, 22₁, 22₂, 22₃, 31₁, 31₂, 31₃) gesetzt und/oder überlagert (21, 21', 22, 22', 31, 31', 32, 32') sind.

6. Bimorphe optische Vorrichtung nach einem der vorhergehenden Ansprüche, **dadurch gekennzeichnet, dass** das optische Element (1) parallelepipedförmig ist, und dass die erste (2) und zweite (3) laterale Fläche entlang der längeren Seite des Rechtecks angeordnet sind.

7. Bimorphe optische Vorrichtung nach Anspruch 6, **dadurch gekennzeichnet, dass** Verhältnis zwischen der Länge L und der Breite 1 des Parallelepipeds zwischen 1 und 100 enthalten ist.

8. Bimorphe optische Vorrichtung nach Anspruch 7, **dadurch gekennzeichnet, dass** die Breite 1 zwischen 10 mm und 80 mm enthalten ist.

9. Bimorphe optische Vorrichtung nach einem der Anspräche 7 oder 8, **dadurch gekennzeichnet, dass** die Länge L zwischen 40 mm und 1500 mm enthalten ist.

10. Bimorphe optische Vorrichtung nach einem der vorhergehenden Ansprüche, **dadurch gekennzeichnet, dass** die Breite l₀ eines Stabes (21, 22, 31, 32, 41, 42, 51, 52) zwischen 2 mm und 30 mm enthalten ist, und dass seine Höhe h₀ zwischen 2 mm und 30 mm enthalten ist.

11. Bimorphe optische Vorrichtung nach einem der Ansprüche 6 oder 10, **dadurch gekennzeichnet, dass** sie außerdem eine dritte (4) und eine vierte (5) laterale gegenüberliegende Fläche umfasst, welche wenigstens zwei der genannten Paare von piezo-elektrischen Keramikstäben (41, 42, 51, 52) aufweisen.

12. Bimorphe optische Vorrichtung nach einem der vorhergehenden Ansprüche, **dadurch gekennzeichnet, dass** die Dicke des optischen Elements (1) 5mm und 100 mm enthalten ist.

13. Bimorphe optische Vorrichtung nach einem der vorhergehenden Ansprüche, **dadurch gekennzeichnet, dass** das optische Element ein Spiegelkörper ist, und dass wenigstens die erste Hauptfläche (6) poliert ist.

14. Bimorphe optische Vorrichtung nach einem der Ansprüche 1-12, **dadurch gekennzeichnet, dass** das optische Element ein Gitter ist, und dass wenigstens die erste Hauptfläche (6) wenigstens ein Gittermuster trägt.

## Claims

1. A bimorph optical device comprising a deformable optical element and active elements made of piezoelectric ceramic provided with electrodes, said elements being controlled in pairs and in opposition so as to produce a compression movement for a first element of a pair and an extension movement for the second element of a pair, the optical element (1) presenting an optically active first main surface (6) and a second main surface (7) opposite to the first main surface, together with at least first and second opposite lateral faces (2, 3), the ceramic active elements comprising at least two pairs of bars (21, 22; 31, 32) of piezoelectric ceramic, the device being **characterized in that** the at least two pairs of bars of piezoelectric ceramic are placed facing each other on said first and second lateral faces (2, 3), each pair comprising two bars (21, 22; 31, 32) placed on one of the first and second lateral faces (2, 3) on either side of a middle surface of the optical element (1) that constitutes the neutral axis thereof.

2. A bimorph optical device according to claim 1, **characterized in that** at least one of the main surfaces (6, 7) intersects the first and second lateral faces (2, 3) along a straight line segment (6₂, 6₃, 6₄, 6₅), and **in that** at least some of said ceramic bars (21, 31) are straight and placed parallel to said straight line segments.

3. A bimorph optical device according to claim 1, **characterized in that** at least one of the main surfaces (6, 7) intersects the first and second lateral faces (2, 3) along a curve segment (62, 63, 64, 65) that is concave or convex, and **in that** at least some of said ceramic bars (21, 31) are straight and are placed parallel to the mean directions of said curve segment.

4. A bimorph optical device according to claim 1, **characterized in that** at least one of the main surfaces (6, 7) intersects the first and second lateral faces (2, 3) along a curve segment (62, 63, 64, 65) that is concave or convex, and **in that** at least some of said ceramic bars (210, 310) are curved and are disposed in such a manner as to follow said curve segment.

5. A bimorph optical device according to claim 1, **characterized in that** at least one ceramic bar comprises at least two piezoelectric ceramic elements that are placed end-to-end (21₁, 21₂, 21₃, 22₁, 22₂, 22₃, 31₁, 31₂, 31₃) and/or that are superposed (21, 21', 22, 22', 31, 31', 32, 32').

6. A bimorph optical device according to any preceding claim, **characterized in that** the optical element (1) is in the form of a rectangular parallelepiped and **in that** said first and second lateral faces (2, 3) extend along the long side of the rectangle.

7. A bimorph optical device according to claim 6, **characterized in that** the ratio of the length L to the width ℓ of said rectangular parallelepiped lies in the range 1 to 100.

8. A bimorph optical device according to claim 7, **characterized in that** the width ℓ lies in the range 10 mm to 80 mm.

9. A bimorph optical device according to claim 7 or claim 8, **characterized in that** the length L lies in the range 40 mm to 1500 mm.

10. A bimorph optical device according to any preceding claim, **characterized in that** the width ℓ₀ of a bar (21, 22, 31, 32, 41, 42, 51, 52) lies in the range 2 mm to 30 mm, and **in that** its height h₀ lies in the range 2 mm to 30 mm.

11. A bimorph optical device according to any one of claims 6 to 10, **characterized in that** it also includes third and fourth opposite lateral faces (4, 5) including at least two of said pairs of piezoelectric ceramic bars (41, 42, 51, 52).

12. A bimorph optical device according to any preceding claim, **characterized in that** the thickness e of the optical element (1) lies in the range 5 mm to 100 mm.

13. A bimorph optical device according to any preceding claim, **characterized in that** the optical element is a mirror body and **in that** at least the first main surface (6) is polished.

14. A bimorph optical device according to any one of claims 1 to 12, **characterized in that** the optical element is a grid, and **in that** at least the first main surface (6) carries at least one grid pattern.
